# EUROPEAN PATENT APPLICATION

(11) **EP 2 068 354 A2**
(43) Date of publication of application: **10.06.2009**
(21) Application number: 08170587.3
(22) Date of filing: 03.12.2008
(51) Int. Cl.: H01L 21/308, H01L 31/18, H01L 31/0224, H01L 21/3205, G03F 1/00, C25D 5/02, H01L 21/768, H01L 21/311

(54) **Method of forming conductive lines and similar features**

(30) Priority: 03.12.2007 US 949280
(71) Applicant: Palo Alto Research Center Incorporated, Palo Alto, California 94304 (US)
(72) Inventor: Limb, Scott J., Palo Alto 94306 (CA); Shrader, Eric J., Belmont 94002 (CA)
(74) Representative: Grünecker, Kinkeldey, Stockmair & Schwanhäusser Anwaltssozietät

(57) **Abstract**

A print-patterned structure may be used as a self-aligned etch and deposition mask. A method of forming conductive lines and other similar features over a plurality of layers comprises forming a print-patterned structure over a first layer. The print-patterned structure is used as an etch mask to expose a portion of a second layer. A seed layer is formed over the exposed portion of the second layer, using the print-patterned structure as a deposition mask. Conductive lines or other features may be formed, for example, by electroplating using the seed layer as a contact pad and the print-patterned structure as deposition mask. The present invention is particularly useful in the formation of features for solar cells and the like where the print-patterned structure may be used to form high aspect ratio features.

## Description

### BACKGROUND OF THE INVENTION

### 1. Field of the Invention.

This invention relates generally to a digital lithography, and more particularly to a printed mask and method of using a single said mask for both etching and plating such as in the fabrication of solar cell devices.

### 2. Description of the Prior Art.

Digital inkjet lithography is a maturing technology designed to reduce the costs associated with photolithographic processes, used often in the fabrication of micro-electronic devices, integrated circuits, and related structures. Digital lithography directly deposits material in desired patterns onto a substrate, taking the place of the delicate and time-consuming photolithography processes used in conventional device manufacturing. One application of digital lithography is the formation of a mask (referred to herein as a "print-patterned mask") for subsequent processing (e.g., plating, etching, implanting, etc.)

Typically, digital lithography involves depositing a print material by moving a print head and a substrate relative to one another along a primary axis (the "print travel axis"). Print heads, and in particular, the arrangements of the ejectors incorporated in those print heads, are optimized for printing along this print travel axis. Printing takes place in a raster fashion, with the print head making "printing passes" across the substrate as the ejector(s) in the print head dispense individual "droplets" of print material onto the substrate or other previously deposited material. Typically, the print head moves relative to the substrate in each printing pass, but the equivalent result may be obtained if the substrate is caused to move relative to the print head (for example, with the substrate secured to a moving stage) in a printing pass. At the end of each printing pass, the print head (or substrate) makes a perpendicular shift relative to the print travel axis before beginning a new printing pass. Printing passes continue in this manner until the desired pattern has been fully printed onto the substrate.

Materials typically printed by digital lithographic systems include phase change material and solutions of polymers, colloidal suspensions, such suspensions of materials with desired electronic properties in a solvent or carrier. For example, U.S. Patents 6,742,884 and 6,872,320 (each incorporated herein by reference) teach a system and process, respectively, for printing a phase change material onto a substrate for masking. According to these references, a suitable material, such as a stearyl erucamide wax, is maintained in liquid phase over an ink-jet style piezoelectric print head, and selectively ejected on a droplet-by-droplet basis such that droplets of the wax are deposited in desired locations in a desired pattern on a layer formed over a substrate. The droplets exit the print head in liquid form, then solidify after impacting the layer, hence the material is referred to as a phase-change material.

Once dispensed from an ejector, a print material droplet attaches itself to the surface through a wetting action as it solidifies in place. In the case of printing phase-change materials, solidification occurs when a heated and liquefied printed droplet loses its thermal energy to the substrate and/or environment and reverts to a solid form. In the case of suspensions, after wetting to the substrate, the carrier most often either evaporates leaving the suspended material on the substrate surface or the carrier hardens or cures. The thermal conditions and physical properties of the print material and substrate, along with the ambient conditions and nature of the print material, determine the specific rate at which the deposited print material transforms from a liquid to a solid, and hence the height and profile of the solidified deposited material.

If two adjacent droplets are applied to the substrate within a time prior to the solidification of either or both droplets, the droplets may wet and coalesce together to form a single, continuous printed feature. Surface tension of the droplet material, temperature of the droplet at ejection, ambient temperature, and substrate temperature are key attributes for controlling the extent of droplet coalescence and lateral spreading of the coalesced material on the substrate surface. These attributes may be selected such that a desired feature size may be obtained.

Digital lithography can be used in the production of a wide variety of device types. One such type of particular interest is solar-based power generation cells (hereinafter "solar cells"). In a typical solar cell, a photo-sensitive material generates a charge when exposed to photons, e.g., from sunlight. Conductive lines formed on the surface of the photosensitive material provide a conduction path for the generated charge. In one common architecture for solar cells, the conductive lines are formed on the front surface and a conductive plane is formed on the back surface of the photosensitive material. Such an arrangement is referred to as a "front side contact structure." In another common solar cell architecture referred to as a "back side contact structure", the conductive lines are only on the back side of the photosensitive material.

In the front side contact structure, the front side conductive lines are formed over a p-n structure and antireflective coating. In order to form the conductive lines, the antireflective coating may be photolithographically patterned and etched, then a conductive metal layer applied and again photolithographically patterned and etched, thereby forming the pattern of conducive lines. Alternatively, once etched, a seed layer material can be applied, patterned, and plated conductive lines formed for example by an electroplating process. As an alternative to photolithography, a silver/frit paste may be silkscreened directly onto the surface of the antireflective coating layer. When the silver/frit is fired, the material spikes through the antireflection coating to make contact with the underlying n+ region. In the back side contact structure, more typical lithography is employed to etch various structural layers and form conductive lines in electrical connection to the p-type or n-type region.

However, each of these prior art process have their disadvantages. For example, the lithographic steps present the disadvantages of: requiring the time needed to perform several pattern and processing steps to etch layers and form the conductive lines; requiring the cost of manufacturing a different reticle for each step; require precise re-registration and alignment from one step to the next; requiring the use of expensive photosensitive resists; and exposing the bulk structure (e.g., crystalline silicon) to extensive handling increasing the risk of damage. The silver/frit process has the disadvantage of introducing stress on the bulk structure which must be offset by stress applied to the surface opposite from which the silver/frit is applied and producing low, wide (low aspect ratio) conductive lines, which block portions of the photosensitive material from receiving photons (i.e., reducing overall efficiency of the device). Each of these disadvantages become more pronounced as the trend of wafer size for the photosensitive material to increase continues.

Thus, there is a need for an alternative method of providing conductive lines (and other features) on the surface of a substrate, and specifically on the surface (front side or back side) of a solar cell. This method should, at a minimum, be gentle in terms of the risk of damage to the substrate, require a reduced number of processing steps and reduced cost as compared to existing methods, and be capable of producing high aspect ratio conductive lines.

### SUMMARY OF THE INVENTION

Accordingly, the present invention is directed to a method for manufacturing conductive lines (and other features) using a single print-patterned mask structure for etching and material plating. More specifically, the present invention is particularly useful for forming relatively high density, high profile conductive lines on the front or back surface of a solar cell with reduced required processing steps and lower cost as compared to existing process for forming lines, such as photolithography and fired silver/frit.

According to one aspect of the present invention, a solar cell substrate is processed such that a p-n junction is present for current generation. An antireflective layer is next applied over the solar cell structure as is well known in the art of solar cell manufacture. A print-patterned mask structure is then formed over the antireflective layer. The print-patterned mask structure is then used as a chemical or plasma etch mask to selectively etch openings into the antireflective layer to expose the p-type or n-type layer for electrical contact. With the print-patterned mask still in place, a seed structure may then be formed in the openings etched into the antireflective layer. An appropriate conductive material may then be deposited, for example by electroplating, in the openings to thereby form a conductive line for extracting current from the photosensitive material.

It will be appreciated that according to the method of the present invention the print-patterned mask is self-aligning as to the openings in the antireflective layer and the subsequently formed conductive lines. Processing steps are reduced, and the processing that takes place is less likely to damage the photosensitive material substrate, as compared to prior techniques of feature formation. Furthermore, the print-patterned mask may be a relatively tall structure, allowing for the formation of high aspect ratio conductive lines in between the mask structures.

According to another aspect of the present invention, the print-patterned mask is removed following formation of the conductive lines (or other features), for example by a chemical strip. According to another feature, the print-patterned mask is formed of a UV curable material, and following formation of the conductive lines, the print-patterned mask is exposed to UV light such that it cures (hardens) and is left in place in the finished solar cell.

According to yet another aspect of the present invention, the print-patterned mask is formed so as to define regions useful for purposes other than conductive lines, such as ground pads, test points, etc.
In one embodiment of the method of claim 9, said first layer is formed over a second layer, and further wherein said channel region is formed to extend completely through said first layer to thereby expose a portion of said second layer, and further wherein said seed layer is formed only on said exposed portion of said second layer.
In a further aspect a method of forming a conductive line over and in electrical contact with a region of a photosensitive substrate is provided. The method comprises the steps of:
forming a first layer of over said substrate;
forming a print-patterned mask structure over and in contact with said first layer, said print-patterned mask structure formed of a plurality of individual droplets so as to have an opening therein;
etching said first layer through said opening in said print-patterned structure to thereby define a channel region exposing a portion of said photosensitive substrate;
depositing a seed layer in said opening over exposed portion of said photosensitive substrate; and
depositing by an electroplating process a plating material over said seed layer in said opening, said electroplating process using said seed layer as a conductive pad, and further using said print-patterned structure as a deposition mask.
In a further embodiment the method further comprises the step depositing a contact metal in said opening prior to depositing said seed layer such that said contact metal is over and in electrical contact with said photosensitive substrate and under and in electrical contact with said seed layer.
According to a further aspect a method of forming a conductive line over and in electrical contact with a region of a photosensitive substrate is provided, wherein said substrate has at least two regions, a first of said regions being of a first polarity, and a second of said regions being of a second polarity opposite of said first polarity. The method comprises the steps of:
forming a passivation layer of over said substrate;
forming a print-patterned mask structure over and in contact with said passivation layer, said print-patterned mask structure formed of a plurality of individual droplets so as to have at least two openings therein, a first of said openings located over said first region of said substrate, a second of said openings located over said second region of said substrate;
etching said passivation layer through said openings in said print-patterned structure to thereby define a first channel region exposing a portion of said first region of said photosensitive substrate and a second channel region exposing a portion of said second region of said photosensitive substrate;
depositing a contact metal in said openings to thereby form a first electrical contact with said first region of said photosensitive substrate and a second electrical contact with said second region of said photosensitive substrate;
depositing a seed layer over said first and second electrical contacts in said openings to thereby form a first seed layer region over said first electrical contact and a second seed layer region over said second electrical contact; and
depositing by an electroplating process a plating material over said seed layer in said openings, said electroplating process using said seed layer as a conductive pad, and further using said print-patterned structure as a deposition mask to thereby form a first conductive line over said first seed layer region and a second conductive line over said second seed layer region.

The above is a summary of a number of the unique aspects, features, and advantages of the present invention. However, this summary is not exhaustive. Thus, these and other aspects, features, and advantages of the present invention will become more apparent from the following detailed description and the appended drawings, when considered in light of the claims provided herein.

### BRIEF DESCRIPTION OF THE DRAWINGS

In the drawings appended hereto like reference numerals denote like elements between the various drawings. While illustrative, the drawings are not drawn to scale. In the drawings:

Fig 1. is a droplet ejection system of a type known in the are used to eject droplets of phase-change material onto a substrate.

Figs. 2 through 7 illustrate various stages in the production of conductive lines, for example for a solar cell, using a print-patterned mask on the front side of a photosensitive substrate according to an embodiment of the present invention.

Fig. 8 is a flow chart illustrating the process of forming a mask on the front side of photosensitive substrate for the production of conductive lines for a solar cell followed for the stages of production illustrated in Figs. 2 through 7.

Figs. 9 through 14 illustrate various stages in the production of conductive lines, for example for a solar cell, using a print-patterned mask on the back side of a photosensitive substrate according to another embodiment of the present invention.
Fig. 15 is a flow chart illustrating the process of forming a mask on the back side of photosensitive substrate for the production of conductive lines for a solar cell followed for the stages of production illustrated in Figs. 9 through 14.

### DETAILED DESCRIPTION OF THE INVENTION

In the following detailed description a method of forming conductive lines and similar features on a substrate, such as might be used in a solar cell, using a print-patterned mask will be described. The method may use the system described below for creating a pattern, typically using a printer to controllably eject individual droplets to form a patterned protective layer or coating over regions of the substrate to define the outline of a feature. Of course, it is to be understood that other printing systems may be used. Regions that were not at one time covered by a protective layer will be subject to deposition (or removal) of materials used to form various features. Thus, feature size will not be limited by droplet size, but instead by how closely droplets can be positioned together without combining to form a single droplet.

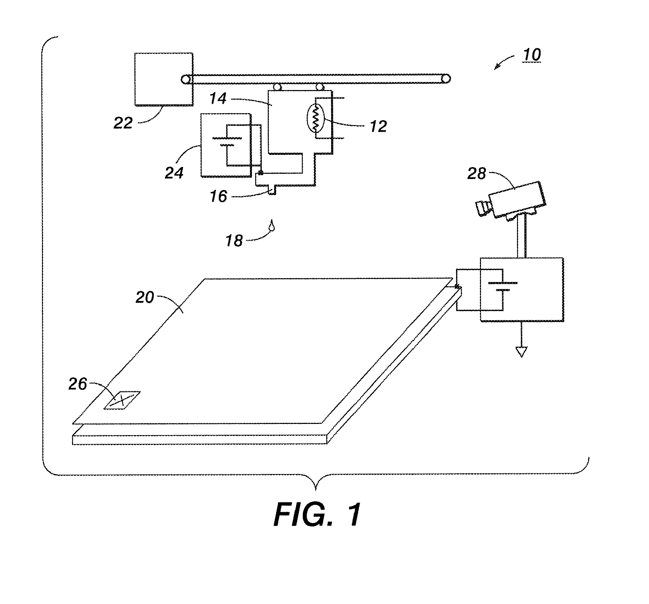

A system suitable for implementing the embodiments of the method set forth herein is described in U.S. Pat. No. 6,972,261, Wong, et al., the disclosure of which is incorporated herein by reference. More specifically, with reference to Fig. 1, there is shown therein the relevant components of a system 10, which includes a heat source 12 that heats a reservoir 14 typically containing a phase-change material. The phase-change material is thereby heated to a temperature that is sufficient to maintain the material in a liquid state. The temperature of the reservoir is generally maintained above 50 degree centigrade and, in some situations, at temperatures above 100 degrees centigrade, a temperature sufficient to liquefy many organic materials that are in the solid phase near room temperature.

The phase-change material may be an organic material that melts at temperatures higher than room temperature. Other desirable characteristics of the phase-change material include that the patterning material is non-reactive with organic and inorganic materials used in typical semiconductor materials processing, and that the phase change material has a high selectivity to etchants. In one embodiment, the phase-change material dissolves in a basic solution (or base-strippable), although in other embodiments other characteristics may be employed to remove (if desired) the phase-change material.

An additional desirable characteristic of the phase-change patterning material is that the resulting pattern should be robust enough to withstand wet-chemical or dry etching processes. When a dry etching process is used, phase change patterning materials with low-vapor pressures may be used. Wax is an example of a phase-change material with the previously described characteristics. Kemamide 180-based waxes from Crompton Corporation of Middlebury, Conn., are but one example of a suitable wax for use as a phase-change patterning material.

In this system, a plurality of droplet sources such as droplet source 16 receives the liquid phase-change marking material from reservoir 14 and outputs droplets 18 for deposition on a substrate 20. The substrate 20 may be maintained at a temperature such that the droplet cools rapidly after deposition.

When increased coalescence between adjacent droplets is required, the substrate temperature can be increased to increase droplet spreading and thereby increase coalescence. When printing lines of Kemamide-based wax from an acoustic ink-jet printer, it has been found that increasing the substrate temperature from 30 degrees to 40 degrees centigrade improves the print quality of the pattern. In the case of Kemamide-based waxes, it has been found that excellent results are achieved when the surface is maintained at 40 degrees centigrade, which is about 20 degrees centigrade below the solid phase point of the wax. At 40 degrees centigrade, the temperature of the substrate is still low enough that the droplet rapidly solidifies upon contacting substrate 20.

After a droplet of phase-change material is deposited on substrate 20, the relative positions of substrate 20 and droplet source 16 are adjusted to reposition droplet source 16 over a second position to be patterned. The repositioning operation may be achieved either by moving droplet source 16 or by moving substrate 20. As shown in FIG. 1, a control circuit 22 moves droplet source 16 in a predetermined pattern over substrate 20. A driver circuit 24 provides energy to droplet source 16, causing ejection of droplets when the droplet source 16 is positioned over a region of substrate 20 to be patterned. By coordinating the movement of droplet source 16 with the timing of droplet source outputs, a pattern can be "printed" on substrate 20.

The presently described method ultimately is used to produce conductive lines and other structures forming a structure for, inter alia, extracting current from a photosensitive substrate. As such, it is desired to form the conductive lines and other structure in specific positions on the surface of antireflective layer 18. Positional registration of the deposition of droplets 22 forming print-patterned mask 20 is routinely accomplished in digital lithographic systems by use of fiduciary marks, digital imaging and processing, and processor controlled relative motion of the ejector and the substrate. The ability to align the formation of a mask over substrate 20 through image processing prior to and while patterning is a significant advantage of the digital-lithographic process over other masking methods.

In order to control and align the movement of droplet source 16, printed fiduciary alignment marks, such as mark 26,may be applied or formed on a surface of the layer upon which the phase-change material is to be applied. Alternative, the fiduciary marks may be on a carrier holding substrate 20 during the deposition process. An image processing system such as a camera 28 may be used to coordinate the orientations of the droplets and the layer on which they are applied. A processing system then adjusts the position of the overlying pattern layer by altering the pattern image file before actual printing of the pattern layer. Positioning adjustment are accomplished in software and translated to movements of the droplet source 16.

Each droplet source may be implemented using a variety of technologies including traditional ink-jet technology. An alternative technology well suited for generating extremely small droplet sizes is the use of sound waves to cause ejection of droplets of patterning material as done in acoustic ink printing systems, as described in, for example, U.S. Pat. No. 6,972,261, Wong et al. Examples of such systems appropriate for the ejection of droplets of phase-change material include: ink-jet systems (such as disclosed in U.S. Patent 4,131,899, which is incorporated herein by reference), ballistic aerosol marking (BAM) devices (such as disclosed in U.S. Patent 6,116,718, which is incorporated herein by reference), acoustic ink printer (AIP) systems (U.S. Patent 4,959,674, which is incorporated herein by reference), carrier-jet ejectors (as disclosed in U.S. patent 5,958,122, which is incorporated by reference herein), deflection-controlled ink-jet systems (such as disclosed in U.S. Patent 3,958,252, which is incorporated herein by reference), etc. Such systems also include pattern transfer systems, such as: xerographic, ionographic, screen, contact, and gravure printing systems, etc.

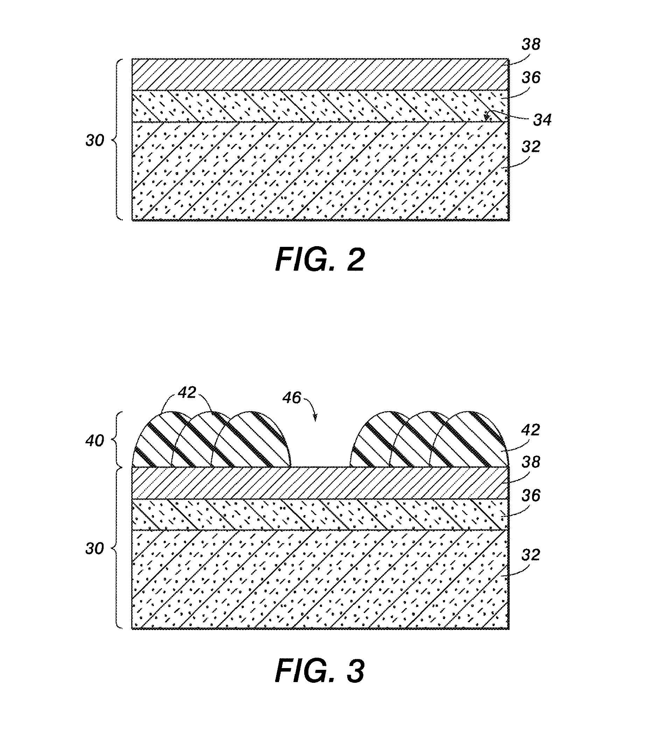

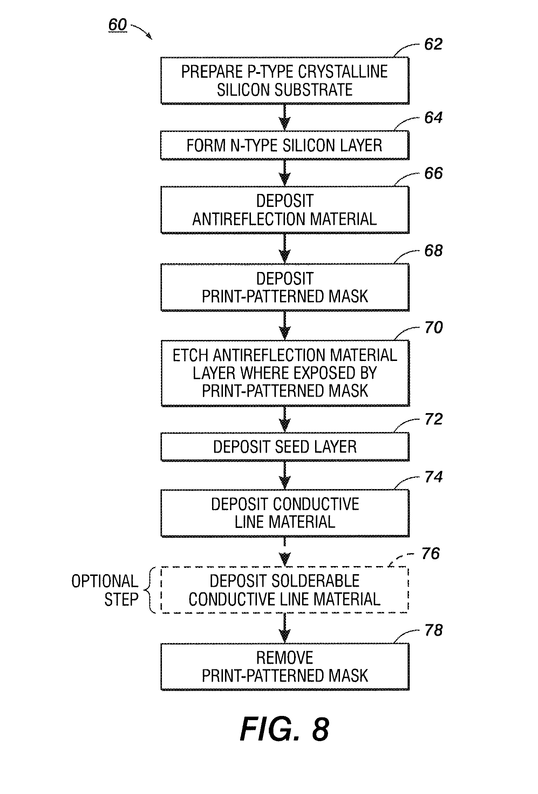

Described in the following section are specific steps for the formation of a print-patterned mask, and the production of structures formed with said mask. Figs. 2 through 7 illustrate a first embodiment of a device at several intermediate stages of its production according to a process illustrated in Fig. 8. While the following description makes specific reference to the device illustrated in Figs. 2 through 7, without making more specific reference thereto the description is following the sequence illustrated in Fig. 8.

With reference to Fig. 2, the process of forming a mask on the front side of photosensitive substrate for the production of conductive lines for a solar cell is illustrated. The process begins with the preparation of the top surface 34 of a single- or poly-crystalline Si (e.g., p-type) substrate 32 for the deposition of various layers thereover. A layer 36 of Si (e.g., n-type) is formed over surface 34 by methods well known in the art. The polarities selected and used in this example may be reversed as will be appreciated by one skilled in the art. An antireflective layer 38 (for example of SiN) is next deposited over layer 36. The antireflective properties of layer 38 enable increased photon capture and a more efficient conversion of photons into an electric current. A print-patterned mask may then be formed over the structure 30.

With reference to Fig. 3, a print-patterned mask 40 in next applied to the surface of layer 38. More specifically, the print-patterned mask 40 is comprised of one or more droplets 42 of the aforementioned phase-change material, such as stearyl erucamide wax, ejected from a printing system of the type described above. The individual droplets may be isolated from one another or coalesced into multi-droplet structures.

For reference, it will be noted that the view of Fig. 3 is in the direction of the long axis of the conductive line to be formed by the present invention. Thus, the deposition of droplets 42 may be such that a channel 46 is formed therebetween which extends into the plane of the figure. Ultimately, it is in channel 26 that a conductive line will be formed.

Droplets 42 (and hence mask 40) may be on the order of 15-40 microns in width and height. The width of channel 46 may be on the order of 10-20 microns. The length (the dimension into the sheet in the figures) of channel 46 may vary depending, for example, upon the nature and size of substrate 42, features formed in or on substrate 42, and the role of the conductive line or other feature ultimately being formed. (All dimensions are for illustration purposes only, and may be controlled for particular applications.) For print-patterned structure of this scale or larger, individual or coalesced droplets may serve to define the width of the mask (i.e., the width of the region between adjacent lines), with the later being illustrated in Fig. 3.

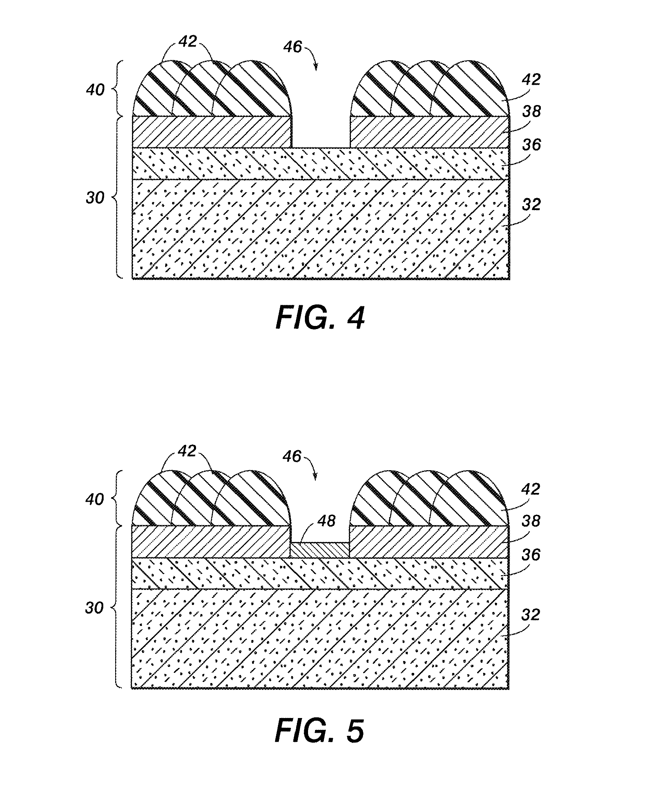

With reference next to Fig. 4, mask 20 is used first as an etch mask. The surface of SiN layer 38 exposed in channel 46 is subjected to an HF chemical etch (or other appropriate etch process). This etch selectively removes the portion of layer 38, deepening channel 46 to thereby expose the underlying portion of the n+ silicon layer 36.

At this stage, with mask 40 remaining in place, a seed layer can be formed or deposited selectively within channel 46. Thus, with reference next to Fig. 5, metallic seed layer 48 is deposited in channel 46 over and in physical and electrical contact with a portion of n+ silicon layer 36. Seed layer 28 may be comprised of nickel deposited by a plating process or an electrodeless process. Other metals can also be applied through plating techniques. Furthermore, conductive nanoparticle ink can be ink jetted to form the seed layer.

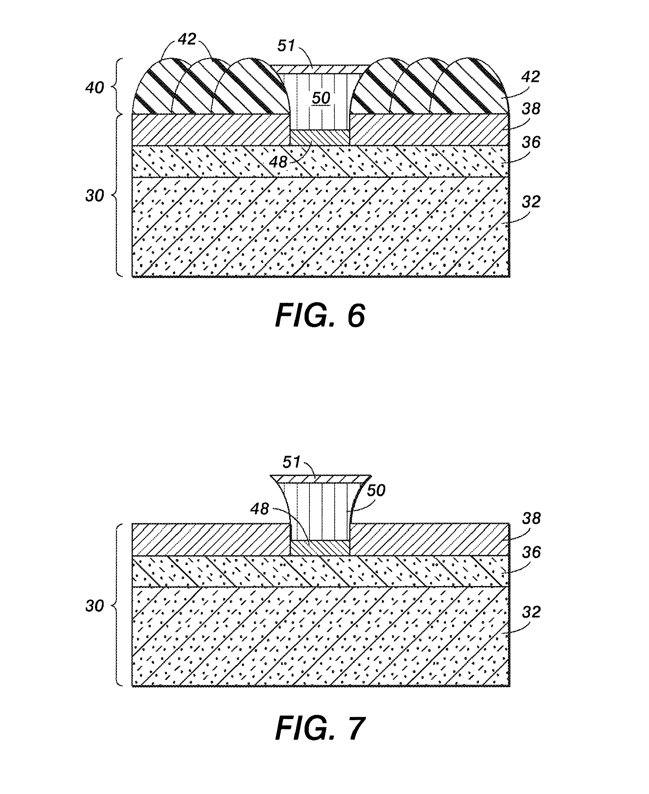

As shown in Fig. 6, following deposition of seed layer 48 material forming a conductive line 50 is deposited in channel 46. The method of deposition is typically electroplating for low cost, high conductivity, and vertical growth. In one embodiment, the metal comprises electroplated nickel. It is to be understood, however, that other metals may be used, including copper and aluminum with a nickel barrier/seed layer. Silver can also be used. The type of metal used depends on the particular device being fabricated. In some cases, the layer could be a metal that can be anodized to form a dielectric layer such as aluminum oxide from a seed layer of aluminum. In other cases, the metal could be grown using vapor deposition techniques to grow a metal or dielectric using organometallic precursors that selectively react with seed layers.

In any case, the film growth occurs primarily in the regions of the exposed seed layer 48 and not on the print-patterned mask 40. Rather, the print-patterned mask 40 servers to constrain the width of conductive line 50 while permitting vertical growth. In this way, the print-patterned mask 40 serves both as an etch mask in a first step and as a growth or deposition mask in a second step. Thus, the mask is self-aligning as between these various steps of manufacturing conductive line or similar feature.

Other top layers 51 may also be plated in order to allow for solderable bond pads. Typically a Sn alloy is used as the top layer for soldering.

Print-patterned mask 40 may then be removed by a method appropriate to the print-patterned material employed. For example, in the event that the print-patterned material is a stearyl erucamide wax, a heated solvent such as acetone may be employed. Alternatives include base solutions. SVC-28 debonding solution, manufactured by Rohm-Hass (dipropylene glycol monomethyl ether, citrus distillate, synthetic isoparraffinic hydrocarbon, and aliphatic hydrocarbon, www.rohmhaas.com), and for Saran, PGMEA (propylene glycol monomethyl ether acetate). We have also found that SRX-400 Advanced Debonding Agent (available from ROHM and HAAS Electronic Materials, Marlborough, MA works for the phase change material removal. SRX-400 is a replacement product for SVC-28 from Rohm-Hass. (The main ingredients for SRX-400 is Aromatic hydrocarbon 50.0% and Aliphatic hydrocarbon 50.0%.) The structure is exposed to the solvent for a time sufficient to permit the solvent to entirely remove the phase-change material droplets. The resulting structure is shown in Fig. 7. As an alternative to the solvent process mentioned above, if a base-soluble wax is used for mask 40, a basic solvent may be used to remove the mask.

It will be appreciated that the resulting conductive line 50 may fabricated to be relatively taller and narrow (high aspect ratio). This is desirable in front side contact structures, as the narrow width of the conductive lines reduces their shadowing of the photosensitive material while the increased height maintains cross-sectional area of the lines, permitting use of the narrower lines without loss of current output as compared to prior techniques.

A similar process may also be applied to the various back side contact structures for solar cells. While there are several different fundamental architectures for back side contact structures, they may share certain common elements and process step including at least some of the following.

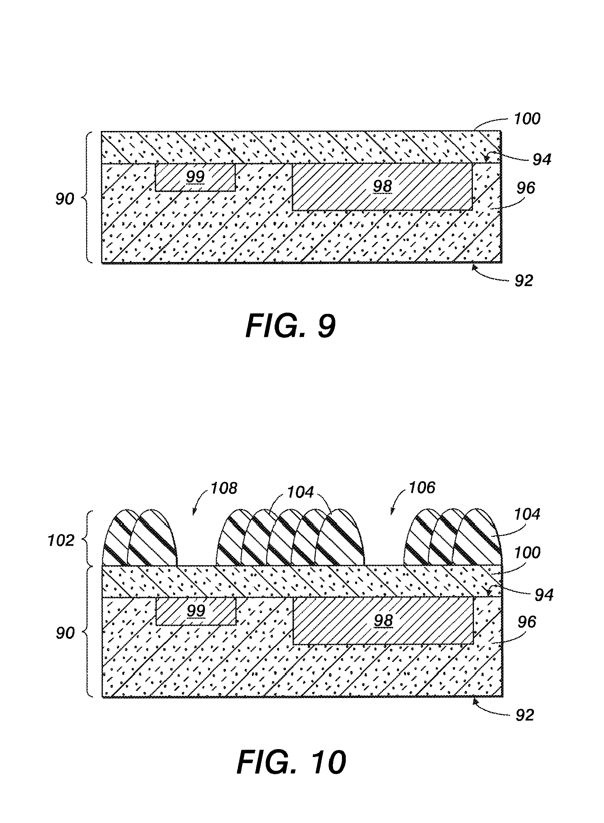

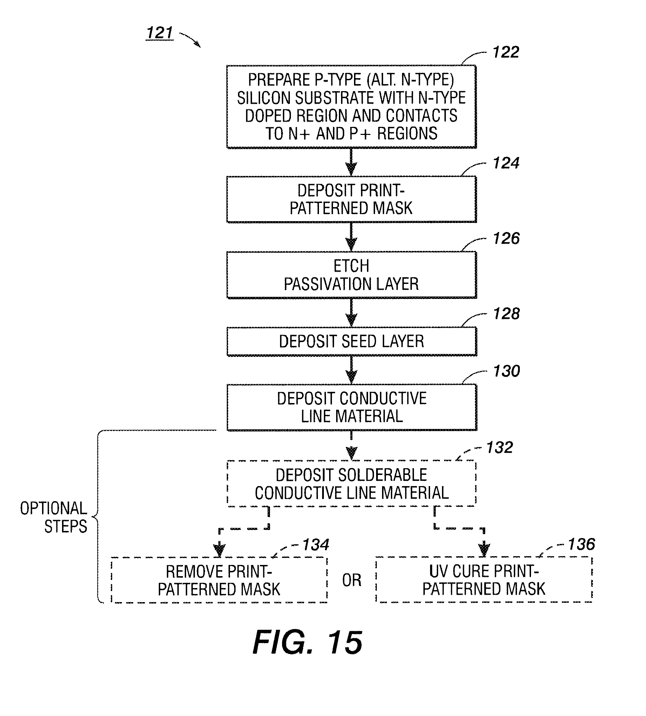

Figs. 9 through 14 illustrate a second embodiment of a device at several intermediate stages of its production according to a process illustrated in Fig. 15. While the following description makes specific reference to the device illustrated in Figs. 9 through 14, without making more specific reference thereto the description is following the sequence illustrated in Fig. 15.

With regard to Fig. 9, there is shown therein a back side structure 90 flipped upside down relative to its final operational orientation. That is, surface 92 is considered the front side of the structure, the side which is oriented toward light in order to receive photons. Processing described hereinbelow therefore is applied to the backside 94 of structure 90.

Backside structure 90 begins a single- or poly-crystalline Si substrate 96 having a first region 98 of first polarity (e.g., n type) and a second region 99 of second polarity (e.g., p+ type) formed therein by methods well known in the art. A passivation/antireflection coating 100 (e.g., SiN) is generally uniformly applied to surface 94, by methods known in the art.

In order to form openings in layer 100 so as to make electrical contact with the p-type and n-type regions, a print-patterned mask structure 102 is next applied to the surface of layer 100. More specifically, the print-patterned mask structure 102 is again comprised of one or more droplets 104 of the aforementioned phase-change material, such as stearyl erucamide wax, ejected from a printing system of the type described above. Print-patterned mask structure 102 is formed to have n-type contact opening 106 and p-type contact opening 108.

For reference, it will be noted that the view of Fig. 3 is in the direction of the long axis of the conductive line to be formed by the present invention. Thus, the deposition of droplets 42 may be such that a channel 46 is formed therebetween which extends into the plane of the figure. Ultimately, it is in channel 26 that a conductive line will be formed.

Droplets 104 (and hence mask 102) may be on the order of 15-40 microns in width and height. The width of openings 106, 108 may be on the order of 10-20 microns. The length (the dimension into the sheet in the figures) of openings 106, 108 may vary depending, for example, upon the nature and size of substrate 96, features formed in or on substrate 96, and the role of the conductive line or other feature ultimately being formed. (All dimensions are for illustration purposes only, and may be controlled for particular applications.) For print-patterned structure of this scale or larger, individual or coalesced droplets may serve to define the width of the mask (i.e., the width of the region between adjacent lines), with the later being illustrated in Fig. 10.

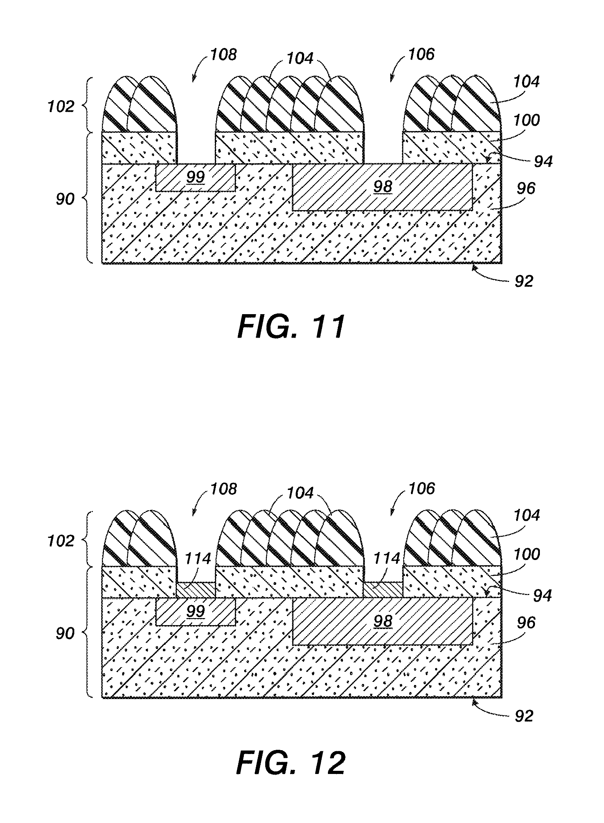

With reference next to Fig. 11, mask 102 is used first as an etch mask. The surface of passivation/antireflective layer 100 exposed in openings 106, 108 is subjected to an HF chemical etch (or other appropriate etch process). This etch selectively removes the portion of layer 100, deepening openings 106, 108 to thereby expose the underlying portion of the n-type region in opening 106 and the p-type region in opening 108.

At this stage, with mask 102 remaining in place, seed layer 114 can next be formed or deposited. Thus, with reference next to Fig. 12, seed layer 114 is deposited over and in physical and electrical contact with n-type 98 region and p-type region 99. Seed layer 114 may be comprised of nickel deposited by a plating process or an electrodeless process. Other metals can also be applied through plating techniques. Typical characteristics of this metal will be to act as a barrier for the current carrying layer and/ or can be sintered to form a silicide in order to improve the contact resistance. Conductive nanoparticle ink can be ink jetted to form the seed layer.

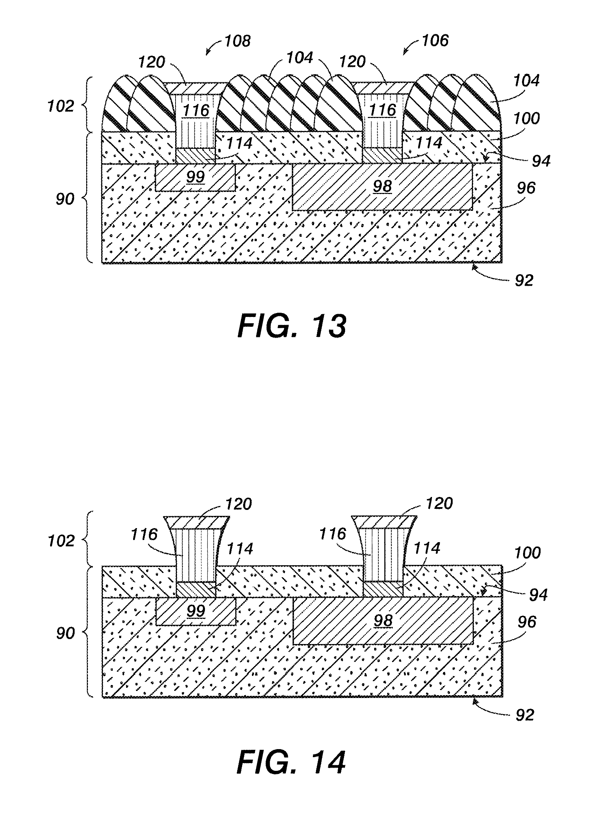

As shown in Fig. 13, following deposition of seed layer 114 material forming a conductive lines 116 is deposited in openings 106, 108, respectively. The method of deposition is typically electroplating for low cost, high conductivity, and vertical growth. In one embodiment, the metal comprises electroplated nickel. It is to be understood, however, that other metals may be used, including copper and aluminum with a nickel barrier/seed layer. Silver can also be used. The type of metal used depends on the particular device being fabricated. In other cases, the metal could be grown using vapor deposition techniques to grow a metal or dielectric using organometallic precursors that selectively react with seed layers.

In any case, the film growth occurs primarily in the regions of the exposed seed layer 114 and not on the print-patterned mask 102. Rather, the print-patterned mask 102 servers to constrain the width of conductive lines 116 while permitting vertical growth. In this way, the print-patterned mask 102 serves both as an etch mask in a first step and as a growth or deposition mask in a second step. Thus, just as with the front side contact structure, the mask is self-aligning as between these various steps of manufacturing conductive lines or similar features on a back side contact structure.

Other top layers 120 may also be plated in order to allow for solderable bond pads. Typically a Sn alloy is used as the top layer for soldering.

Print-patterned mask 102 may then be removed by a method appropriate to the print-patterned material employed. For example, in the event that the print-patterned material is a stearyl erucamide wax, a heated solvent such as acetone may be employed. Alternatives include base solutions. SVC-28 debonding solution, manufactured by Rohm-Hass (dipropylene glycol monomethyl ether, citrus distillate, synthetic isoparraffinic hydrocarbon, and aliphatic hydrocarbon, www.rohmhaas.com), and for Saran, PGMEA (propylene glycol monomethyl ether acetate). We have also found that SRX-400 Advanced Debonding Agent (available from ROHM and HAAS Electronic Materials, Marlborough, MA works for the phase change material removal. SRX-400 is a replacement product for SVC-28 from Rohm-Hass. (The main ingredients for SRX-400 is Aromatic hydrocarbon 50.0% and Aliphatic hydrocarbon 50.0%.) The structure is exposed to the solvent for a time sufficient to permit the solvent to entirely remove the phase-change material droplets. The resulting structure is shown in Fig.14. Alternatively, since photons are not incident on the back side of the solar cell there is less concern about shadowing effects. Thus, mask layer 106 may be left in place on the structure following a UV curing and hardening step (with the resulting structure appearing as shown in Fig. 13). As an alternative to the solvent process mentioned above, if a base-soluble wax is used for mask 102, a basic solvent may be used to remove the mask.

While a plurality of preferred exemplary embodiments have been presented in the foregoing detailed description, it should be understood that a vast number of variations exist, and these preferred exemplary embodiments are merely representative examples, and are not intended to limit the scope, applicability or configuration of the invention in any way. For example, while described primarily as a method for producing an array of parallel conductive lines, the print-patterned features according to the present invention may be formed in the pattern of a 2-dimensional grid or other arrangement of features, for example as might be employed in a photo-sensor or similar device. In addition, it will be appreciated that our process may be employed with multiple layer structures and sequentially on layers stacked above one another. Furthermore, while a so-called back-junction structure has been described herein, the process of the present invention may also be employed in many other structure designs, such as emitter wrap-though structures (see, e.g., U.S. Patent 7,170,001), metallization wrap-around structures (see, e.g., U.S. Patent 5,620,904), etc.

## Claims

1. A method of manufacturing an etched structure, comprising the steps of:
forming over a first layer a print-patterned mask structure, said print-patterned structure formed of a material having a melting temperature;
etching said first layer, using said print-patterned mask structure as an etch mask, to thereby define a channel region;
depositing by a plating process a plating material in said channel region, using said print-patterned structure as a deposition mask.

2. The method of claim 1, wherein said print-patterned mask structure is formed of a phase change material.

3. The method of claim 2, wherein said phase change material is a stearyl erucamide wax.

4. The method of claim 1, further comprising the step of removing said print-patterned mask structure following the step of depositing said plating material.

5. The method of claim 4, wherein the step of removing said print-patterned mask structure comprises exposing said print-patterned mask structure to a heated solvent, the temperature of the solvent being above the melting temperature of the material forming the print-patterned mask structure.

6. The method of claim 1 wherein said plating material forms a conductive line on the surface of a solar cell.

7. The method of claim 6 wherein said conductive line has a tapered profile.

8. The method of claim 7, wherein said tapered profile is concave.

9. A method of manufacturing an etched structure, comprising the steps of:
forming over a first layer a print-patterned mask structure, said print-patterned structure formed of a material having a melting temperature;
etching said first layer, using said print-patterned mask structure as an etch mask, to thereby define a channel region;
depositing a seed layer in said channel region, using said print-patterned mask structure as a deposition mask; and
depositing by an electroplating process a plating material over said seed layer in said channel region, said electroplating process using said seed layer as a conductive pad, and further using said print-patterned structure as a deposition mask.

10. The method of claim 9, wherein said print-patterned mask structure is formed of a phase change material.

11. The method of claim 11, wherein said phase change material is a stearyl erucamide wax.

12. The method of claim 9, further comprising the step of removing said print-patterned mask structure following the step of depositing said plating material.

13. The method of claim 12, wherein the step of removing said print-patterned mask structure comprises exposing said print-patterned mask structure to a heated solvent, the temperature of the solvent being above the melting temperature of the material forming the print-patterned mask structure.

14. The method of claim 9, wherein said plating material forms a conductive line on the surface of a solar cell.

15. The method of claim 14, wherein said conductive line has a tapered profile.
